(19) Europäisches Patentamt / European Patent Office / Office européen des brevets

(11) **EP 2 015 352 A2**

(12) **EUROPEAN PATENT APPLICATION**

(43) Date of publication:
**14.01.2009 Bulletin 2009/03**

(51) Int Cl.:
*H01L 21/3213* (2006.01)

(21) Application number: **08159218.0**

(22) Date of filing: **27.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **05.07.2007 US 948129 P**
**07.09.2007 US 970844 P**
**06.05.2008 US 50848**

(71) Applicants:
• **INTERUNIVERSITAIR MICROELEKTRONICA CENTRUM VZW**
**3001 Leuven (BE)**

• **Katholieke Universiteit Leuven Research & Development**
**3000 Leuven (BE)**

(72) Inventor: **Dictus, Dries**
**B-3010, Kessel-lo (BE)**

(74) Representative: **Bird, William Edward et al**
**Bird Goën & Co.**
**Klein Dalenstraat 42A**
**3020 Winksele (BE)**

(54) **Photon induced etching of copper**

(57)    The present invention provides a method for removing at least part of a copper comprising layer (4) from a substrate (1), the substrate (1) comprising at least a copper comprising surface layer (4). The method comprises in a first reaction chamber converting at least part of the copper comprising surface layer (4) into a copper halide surface layer (5) and in a second reaction chamber removing at least part of the copper halide surface layer (5) by exposing it to a photon comprising ambient (6), thereby initiating formation of volatile copper halide products (8). During exposure to the photon comprising ambient (6), the method furthermore comprises removing the volatile copper halide products (8) from the second reaction chamber to avoid saturation of the volatile copper halide products (8) in the second reaction chamber. The method according to embodiments of the present invention may be used to pattern copper comprising layers. For example, the method according to embodiments of the invention may be used to form copper comprising interconnect structures in a semiconductor device.

FIG. 1

**Description**

**Technical field of the invention**

The present invention relates to the removal or etching of copper from a substrate. More particular, the present invention relates to the removal or etching of copper from a substrate comprising at least a copper comprising surface layer by using a photon comprising ambient.

**Background of the invention**

In the field of semiconductor processing, typically damascene processes are used to form copper-based interconnects. In damascene processes, trenches are etched in low dielectric constant materials and these trenches are then subsequently filled up to create the copper interconnects. However, nowadays feature sizes are more and more shrinking through which this approach becomes more and more challenging.

First, there are issues related to etching of low-k materials. During etching such materials may be damaged through which the k-value of the material may increase, also referred to as low-k damage. The same applies for photoresist removal after the etch process, which is also known to produce low-k damage. According to the damascene process, subsequent to the etching process, the trenches are coated with a barrier layer and filled with copper. This filling procedure is difficult in the sense that bottom-up filling is required to obtain complete filling of the trenches and that large grains are desired for low resistivity and optimal electromigration properties. A further issue is the performance of chemical mechanical polishing (CMP) of the copper with all its inherent problems as known by a person skilled in the art.

An alternative to the damascene process is the classical pathway as was used before for aluminium as an interconnect material. When applying this process in the formation of copper interconnections, this requires copper films to be patterned. Dry etching of copper could overcome these problems since in that case the low-k materials do not have to be etched and copper does not have to be planarized. Moreover, etched copper lines may have a lower resistivity and improved electromigration resistance compared to those developed using a damascene process. This is mostly because the grain growth of copper, when deposited on a flat surface, is not obstructed like it is in narrow trenches in a damascene approach. The resulting larger grain size may lead to less scattering of electrons at grain boundaries.

Because of the above, there is a need to explore the possibilities of dry etching of a copper layer. Up to now, dry etching of copper was hardly impossible because high temperatures of up to 200°C were needed to make copper chloride ($Cu_xCl_y$) or copper bromide ($Cu_xBr_y$) volatile. At such high temperatures it is impossible to realize anisotropic etching of narrow structures in the nanometre dimensions. To avoid high temperature etching, attempts were done in the prior art in which first copper is converted into halogenated copper, also referred to as a copper halide ($Cu_xCl_y$ and/or $Cu_xBr_y$) by exposing it to a $Cl_2$ of HBr plasma at low temperatures (60°C) ("Room-temperature copper etching based on a plasma-copper reaction", Kuo et al., Applied Physics Letters, Vol. 78, No. 7, 2001). In a second step, the copper halide is then removed using a wet removal step (e.g. a 5% HCl solution). This low temperature method is however unsuitable and not accurate enough to pattern structures with nanometer dimensions. The conversion of copper into $Cu_xCly$ and/or $Cu_xBry$ happens very fast and thick layers of $Cu_xCly$ and/or $Cu_xBry$ can be formed. Furthermore, copper seems to diffuse very fast through $Cu_xCly$ and/or $Cu_xBry$ such that anisotropical etching becomes impossible. Another approach shown in literature (US 5,221,426) is the etching of copper using powerful laser beams leading to local volatilization of copper species. However, this method also leads to unwanted heat generation.

**Summary of the invention**

It is an object of embodiments of the present invention to provide a method for removing at least part of a copper comprising layer from a substrate, the substrate comprising at least a copper comprising surface layer.

The above objective is accomplished by a method according to embodiments of the present invention.

In a first aspect, the present invention provides a method for removing at least part of a copper comprising layer from a substrate, the substrate comprising at least a copper comprising surface layer. The method comprises:

- in a first reaction chamber converting at least part of the copper comprising surface layer into a copper halide surface layer, i.e. a surface layer comprising a copper halide compound, e.g. a copper halide compound different from a copper fluoride compound,
- in a second reaction chamber removing at least part of the copper halide surface layer by exposing it to a photon comprising ambient, thereby initiating formation of volatile copper halide products, and
- during exposure to the photon comprising ambient, removing the volatile copper halide products from the second reaction chamber to avoid saturation of the volatile copper halide products in the second reaction chamber.

According to embodiments of the invention, the first and second reaction chamber may be the same. According to other embodiments of the invention, the first and second reaction chambers may be different.

A method according to embodiments of the present invention may be used to pattern copper comprising layers. For example, a method according to embodiments of the invention may be used to form copper comprising interconnect structures in a semiconductor device.

According to embodiments of the invention a copper comprising layer refers to a layer comprising between 10 atomic % and 100 atomic % copper. According to embodiments of the invention, a copper comprising layer may refer to a layer comprising at least between 10 atomic % and 50 atomic % copper.

Removing the volatile copper halide products from the reaction chamber is to avoid saturation of the volatile copper halide product in the reaction chamber. In other words, the partial pressure of the halogenated products in embodiments of the present invention is such that no saturation is reached. The intensity of the plasma to initiate the volatilisation of the copper halide from the surface may be in the mW/cm$^2$ range. The intensity of the plasma can be tuned by the applied power and pressure. Volatilization of copper halides is already possible using a He, Ar or H comprising plasma having a power in the range of between 300 Watt and 1000 Watt at a pressure in the range of between 5 mTorr (0.67 Pa) and 80 mTorr (10.67 Pa).

It is an advantage of methods according to embodiments of the present invention that it uses photon induced reactions and that it can be used at low temperatures. It is an advantage of methods according to embodiments of the invention that it does not require the use of high temperatures, e.g. higher than 150°C, to remove at least part of the copper layer. A method according to embodiments of the present invention may be performed at a temperature of between 20°C and 80°C.

According to embodiments of the invention, converting at least part of the copper comprising surface layer into a copper halide surface layer may be performed by exposing at least part of the copper comprising surface layer to a halogen comprising gas such as e.g. a $BCl_3$, HBr, $Br_2$, $Cl_2$, $I_2$, HCl and/or HI gas.

According to other embodiments of the invention, converting at least part of the copper comprising surface layer into a copper halide surface layer may be performed by exposing at least part of the copper comprising surface layer to a halogen comprising plasma. The halogen comprising plasma may, for example, be a Br, I and/or Cl comprising plasma. The halogen comprising plasma may, for example, be formed in a reactive ion etching chamber using $BCl_3$, HBr, $Br_2$, $Cl_2$, $I_2$, HCl and/or HI gasses.

Exposing at least part of the copper comprising surface layer to a halogen comprising plasma may be performed with a halogen comprising plasma at a power of between 200 Watt and 1000 Watt, a pressure of between 4 mTorr (0.53 Pa) and 80 mTorr (10.67 Pa) and a flow of between 50 sccm and 500 sccm, for example a plasma at a power of 600 Watt and a pressure of 10 mTorr (1.33 Pa) may be used.

According to embodiments of the invention, exposing the copper halide surface layer to a photon comprising ambient may be performed by exposing the copper halide surface layer to a He, Ar or H comprising plasma.

According to embodiments of the invention, the copper halide surface layer may comprise $Cu_xCl_y$ and the photon comprising ambient may be a He plasma, and exposing the copper halide surface layer to a photon comprising ambient may be performed at a power of 1000 Watt and a pressure of 30 mTorr (4 Pa), with or without the use of substrate bias. The exposure time period is dependent on the amount of copper to be removed (or dimensions of the structures to be patterned).

According to other embodiments of the invention, the copper halide surface layer may comprise $Cu_xBr_y$ and the photon comprising ambient may be a He plasma, and exposing the copper halide surface layer to a photon comprising ambient may be performed at a power of 1000 Watt and a pressure of 80 mTorr (10.67 Pa), with or without substrate bias. The exposure time period is dependent on the amount of copper to be removed (or dimensions of the structures to be patterned).

According to still further embodiments of the invention, the copper halide surface layer may comprise $Cu_xI_y$ and the photon comprising ambient may be a He plasma, and exposing the copper halide surface layer to a photon comprising ambient may be performed at a power of 1000 Watt and a pressure of 80 mTorr (10.67 Pa), with or without substrate bias. The exposure time period is dependent on the amount of copper to be removed (or dimensions of the structures to be patterned).

According to embodiments of the invention converting at least part of the copper comprising surface layer into a copper halide surface layer, also referred to as halogenation, and exposing the copper halide surface layer to a photon comprising ambient may be performed simultaneously in a same reaction chamber. For example, the simultaneous reaction may be performed in a reactive ion etching chamber in which a plasma is present that comprises at least a halogen compound and a photon inducing compound e.g. originating from a He, Ar or H plasma. According to the present example, the plasma may comprise as main compounds He, Ar and/or H (more than 90%) and may furthermore comprise halogen compounds. The amount of halogen compounds in the plasma (e.g. Cl, Br and/or I radicals and ions) may be in the range of a few percentages of the total plasma composition. The plasma may furthermore comprise inert compounds and/or compounds such as fluorocarbon based compounds (e.g. originating from $CF_4$) to obtain passivation (e.g. sidewall passivation) removal of the copper from the substrate.

The method may comprise providing a substrate comprising at least a copper comprising surface layer. Providing such a substrate may be performed by:

- providing a substrate, and
- depositing a copper comprising surface layer onto the substrate.

According to embodiments of the invention, depositing a copper comprising surface layer onto the substrate may, for example, be performed by electrochemical plating (ECP) or Physical Vapour Deposition (PVD). An extra annealing step may be performed on the deposited copper layer in order to recrystallize the copper to obtain larger grains.

An advantage of first depositing a copper comprising layer and then etching interconnect structures into the copper comprising layer is the fact that these copper interconnect structures have much bigger grains and hence less grain boundaries compared to copper interconnect structures obtained using damascene technology.

According to embodiments of the invention, the method may furthermore comprise, before providing a copper comprising surface layer, providing a protecting layer and/or a barrier layer onto the substrate. The barrier layer may be used to avoid diffusion of copper into the substrate. According to embodiments of the invention, the method may comprise providing one of a protective layer or a barrier layer. According to other embodiments of the invention, the method may comprise providing both a protective layer and a barrier layer.

The method may furthermore comprise, before converting at least part of the copper comprising surface layer into a copper halide surface layer, providing a lithographic pattern onto the copper comprising surface layer.

Providing a pattern onto the copper surface layer may be performed by:

- providing a layer of material, e.g. a photosensitive lithographic layer (e.g. resist), onto the copper comprising surface layer, and
- patterning the layer of photosensitive material by lithographic patterning to create at least one hole in the layer.

According to embodiments of the invention, the method may furthermore comprise, after provision of a pattern onto the copper comprising surface layer and removing at least part of the copper comprising layer, removing the photosensitive layer.

The method may furthermore comprise, before converting at least part of the copper comprising surface layer into a copper halide surface layer, cleaning the substrate. Cleaning may, for example, be done by using a $H_2$ or $N_2$ plasma.

In a further aspect, the present invention provides the use of a method according to embodiments of the invention for patterning a copper comprising layer. According to embodiments of the invention the patterning of the copper layer may be used to define interconnect structures in the copper layer, the interconnect structures can be either trenches or vias. After patterning the interconnect structures, a dielectric layer may be deposited onto the interconnect structures.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

All figures are intended to illustrate some aspects and embodiments of the present invention. The figures are depicted in a simplified way for reason of clarity. Not all alternatives and options are shown and therefore the invention is not limited to the content of the given drawings. Like numerals are employed to reference like parts in the different figures.

Fig. 1 illustrates the principle of a method according to embodiments of the present invention.
Fig. 2 schematically illustrates the desorption induced by electronic transition (DIET) mechanisms to achieve the photon induced copper desorption according to according to embodiments of the present invention.
Fig. 3 illustrates formation of volatile copper halide product and the possibility of re-deposition of these copper halide product onto the substrate.

Figs. 4A to 4F illustrate an example of the use of a method according to embodiments of the invention.

Fig. 5 illustrates passivation of a trench during use of a method according to embodiments of the present invention.

Fig. 6 illustrates wafer loss (loss of $Cu_xCl_y$ due to volatilization of $Cu_xCl_y$) during exposure of a $Cu_xCl_y$ layer to a halogen comprising plasma as a function of the partial pressure of He in the plasma chamber.

## Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Moreover, the term top and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following term is provided solely to aid in the understanding of the invention.

The term "pattern" as referred to in the claims and the description is used to define structures (e.g. vias, trenches,...) in a layer deposited onto a substrate, e.g. a wafer substrate. The patterns are formed on the wafer substrates using patterning tools known by a person skilled in the art as a combination of lithography techniques (photolithography and e-beam lithography) and etching techniques (such as reactive ion etching (RIE)).

The invention will now be described by a detailed description of several embodiments of the invention. It is clear that other embodiments of the invention can be configured according to the knowledge of persons skilled in the art without departing from the true spirit or technical teaching of the invention as defined by the appended claims.

The present invention provides a method for removing at least part of a copper comprising layer from a substrate, the substrate comprising at least a copper comprising surface layer. The method comprises:

- in a first reaction chamber converting at least part of the copper comprising surface layer into a copper halide surface layer, i.e. a surface layer comprising a copper halide compound, e.g. a copper halide compound different from a copper fluoride compound,
- in a second reaction chamber removing at least part of the copper halide surface layer, i.e. a surface layer comprising a copper halide compound, e.g. a copper halide compound different from a copper fluoride compound, by exposing it to a photon comprising ambient, thereby initiating formation of volatile copper halide products, and

- during exposure to the photon comprising ambient, removing the volatile copper halide products from the second reaction chamber so as to avoid saturation of the volatile copper halide products in the second reaction chamber, thereby preventing re-deposition of the volatile copper halide products onto the substrate.

According to embodiments of the invention, the first and second reaction chamber may be the same. In other words, according to embodiments of the invention, converting at least part of the copper comprising surface layer into a copper halide surface layer and removing at least part of the copper halide surface layer may be performed in a same reaction chamber. According to these embodiments, converting at least part of the copper comprising surface layer into a copper halide surface layer and removing at least part of the copper halide surface layer may be performed simultaneously or in subsequent steps. According to other embodiments of the invention, the first and second reaction chambers may be different. In other words, according to these embodiments, converting at least part of the copper comprising surface layer into a copper halide surface layer and removing at least part of the copper halide surface layer may be performed in different reaction chambers.

According to embodiments of the invention a copper comprising layer refers to a layer comprising between 10 atomic % and 100 atomic % copper. According to embodiments of the invention, a copper comprising layer comprising layer may refer to a layer comprising at least between 10 atomic % and 50 atomic % copper.

Removing the volatile copper halide products from the reaction chamber is to avoid saturation of the volatile copper halide product in the reaction chamber. In other words, in embodiments of the present invention the partial pressure of the halogenated products is such that no saturation is reached. The intensity of the plasma to initiate the volatilisation of the copper halide from the surface may be in the mW/cm$^2$ range. The intensity of the plasma can be tuned by the applied power and pressure. Volatilization of copper halides is already possible using a He, Ar or H comprising plasma having a power in the range of between 300 Watt and 1000 Watt at a pressure in the range of between 5 mTorr (0.67 Pa) and 80 mTorr (10.67 Pa) (see further).

It is an advantage of a method according to embodiments of the invention that it does not require high temperatures, e.g. temperatures of higher than 150°C, to remove the copper halide compound of the copper halide surface layer or in other words to form volatile copper halide products.

A method according to embodiments of the present invention may be used to pattern copper comprising layers. For example, a method according to embodiments of the invention may be used to form copper comprising interconnect structures in a semiconductor device.

According to embodiments of the invention and as already mentioned above, converting at least part of the copper comprising surface layer into a copper halide surface layer and exposing the copper halide surface layer to a photon comprising ambient to initiate formation of volatile copper halide products may be performed simultaneously in a same reaction chamber, e.g. in a reactive ion etching chamber. The simultaneous reaction can be performed in a reactive ion etching chamber in which the plasma comprises at least a halogen compound to perform the conversion of copper into a copper halide compound and a photon inducing compound e.g. originating from a He, Ar or $H_2$ plasma to make the copper halide compound volatile. The plasma may further comprise inert compounds and/or compounds such as fluorocarbon based compounds (e.g. $CF_4$) to obtain passivation (e.g. sidewall passivation) during etching.

In the following description, removal of copper from the substrate may also be referred to as etching of the copper comprising surface layer.

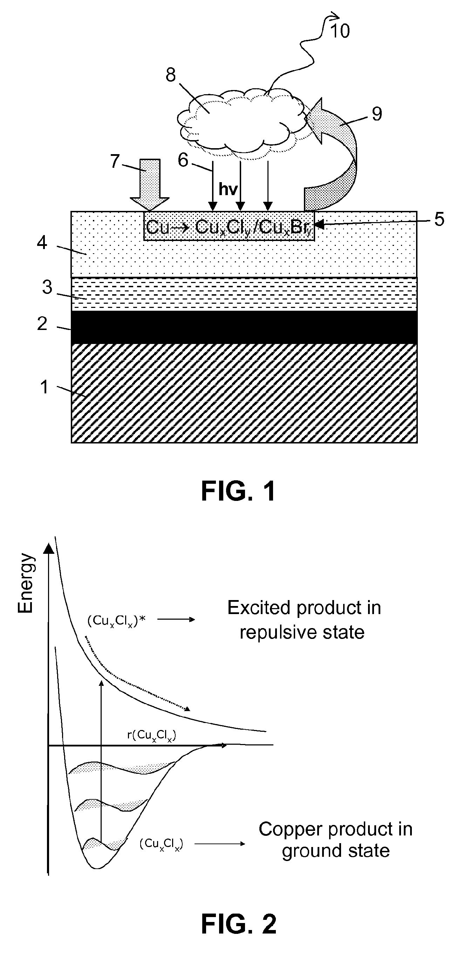

Fig. 1 illustrates a method for removal of copper from a copper comprising layer on a substrate 1, the substrate comprising at least a copper comprising surface layer 4. According to embodiments of the invention, the substrate 1 may be any suitable substrate. In embodiments of the present invention, the term "substrate" may include any underlying material or materials that may be used, or upon which a device, a circuit or an epitaxial layer may be formed. In other alternative embodiments, this "substrate" may include a semiconductor substrate such as e.g. doped silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a $SiO_2$ or a $Si_3N_4$ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or copper layer. An example of a suitable substrate 1 which may be used with embodiments of the present invention may be a Si wafer. For example, the substrate 1 may be a 200 mm Si wafer onto which a copper comprising surface layer 4 is provided by e.g. electrochemical deposition. During deposition, the wafer temperature may be around 60°C. According to still further embodiments of the invention, the substrate 1 may be a bulk copper substrate.

According to embodiments of the invention, in between the substrate 1 and the copper comprising surface layer 4, optionally a protecting layer 2 and/or a barrier layer 3 may be present. The protecting layer 2 may, for example, be a $SiO_2$ layer, and may, for example, have a thickness of 500 nm. The barrier layer 3 may, for example, be a TaN, TiN, TaN/TiN or SiC layer and may have a thickness in the range of, for example, 10 nm to 20 nm. The barrier layer 3 may be used to avoid diffusion of copper into the substrate 1. It has to be noted that, according to embodiments of the invention and as illustrated in Fig. 1, both a protecting layer 2 and a barrier layer 3 may be provided. According to other embodiments of the invention, only one of a protecting layer 2 or a barrier layer 3 may be provided. According to still other embodiments, none of these layers 2, 3 may be provided.

The method according to embodiments of the invention may comprise in a first step converting at least part of the copper comprising surface layer 4 into a copper halide surface layer 5, i.e. a surface layer comprising a copper halide compound, e.g. a copper halide compound different from a copper fluoride compound. Examples of such copper halide compounds may be $Cu_xCl_y$ or $Cu_xBr_y$. According to embodiments of the invention, converting at least part of the copper comprising surface layer 4 into a copper halide surface layer 5 may be performed by exposing at least part of the copper comprising surface layer 4 to a halogen comprising gas such as e.g. a $BCl_3$, HBr, $Br_2$, $Cl_2$, $I_2$, HCl and/or HI gas. According to other embodiments of the invention, converting at least part of the copper comprising surface layer 4 into a copper halide surface layer 5 may be performed by exposing at least part of the copper comprising surface layer 4 to a halogen comprising plasma. The halogen comprising plasma may be formed in a reactive ion etching chamber using $BCl_3$, HBr, $Br_2$, $Cl_2$, $I_2$, HCl and/or HI gasses. Exposing at least part of the copper comprising surface layer 4 to a halogen comprising plasma may be performed with a halogen comprising plasma at a power of between 200 Watt and 1000 Watt, a pressure of between 4 mTorr (0.53 Pa) and 80 mTorr (10.67 Pa) and a flow rate of between 50 sccm and 500 sccm, for example a plasma at 600 Watt and 10 mTorr (1.33 Pa) may be used.

In a next step, at least part of the copper halide surface layer 5, i.e. a surface layer comprising a copper halide compound, e.g. a copper halide compound different from a copper fluoride compound, is removed by exposing the copper halide surface layer 5 to a photon comprising ambient 6, thereby initiating formation of volatile copper halide products 8. According to embodiments of the invention, exposing the copper halide surface layer 5 to a photon comprising ambient 6 may be performed by exposing the copper halide surface layer 5 to a He, Ar or H comprising plasma. According to embodiments of the invention, the copper halide surface layer 5 may comprise $Cu_xCl_y$ and the photon comprising ambient 6 may be a He plasma. According to these embodiments, exposing the copper halide surface layer 5 to the photon comprising ambient 6 may be performed at a power of 1000 Watt and a pressure of 30 mTorr (4 Pa) with or without the use of substrate bias. The exposure time period is dependent on the amount of copper to be removed and/or on the dimensions of the structures to be patterned. According to other embodiments of the invention, the copper halide surface layer 5 may comprise $Cu_xBr_y$ and the photon comprising ambient 6 may be a He plasma. According to this example, exposing the copper halide surface layer 5 to a photon comprising ambient 6 may be performed at a power of 1000 Watt and a pressure of 80 mTorr (10.67 Pa), with or without substrate bias. Again, the exposure time period is dependent on the amount of copper to be removed and/or the dimensions of the structures to be patterned. According to still further embodiments of the invention, the copper halide surface layer 5 may comprise $Cu_xI_y$ and the photon comprising ambient 6 may be a He plasma. According to these embodiments, exposing the copper halide surface layer 5 to a photon comprising ambient 6 may be performed at a power of 1000 Watt and a pressure of 80 mTorr (10.67 Pa), with or without substrate bias. The exposure time period is dependent on the amount of copper to be removed and/or the dimensions of the structures to be patterned.

The mechanism of photon induced desorption of a halogenated Cu surface most likely happens because photons from the plasma interact in such a way with the halogenated copper surface that electronic excitations are created in the surface molecules. This may lead to breaking of surface bonds and/or excited molecules being repelled from the surface. A possible potential energy diagram for such a process is illustrated in Fig. 2, which schematically illustrates the desorption induced by electronic transitions (DIET) mechanism to obtain photon induced copper desorption according to according to embodiments of the present invention.

In the example given in Fig. 1 converting at least part of the copper comprising surface layer 4 into a copper halide surface layer 5 and exposing the copper halide surface layer 5 to a photon comprising ambient 6 may be performed simultaneously. At least part of the copper comprising surface layer 4 may be converted to a copper halide surface layer 5 by exposure to a halogen comprising plasma (indicated by arrow with reference number 7 in Fig. 1). By simultaneously exposing the copper halide surface layer 5 to a photon comprising ambient 6, formation of volatile copper halide products 8 is initiated (indicated by arrow with reference number 9). By continuously removing the volatile copper halide products 8 from the reaction chamber (indicated by arrow with reference number 10 in Fig. 1) during exposure of the copper halide surface layer 5 to the photon comprising ambient 6, saturation of the volatile copper halide products 8 in the reaction chamber is avoided such that re-deposition of these copper halide products 8 onto the substrate 1 is prevented.

Removal of the volatile copper halide products 8 in embodiments of the present invention is such that no saturation levels are reached, because in that case the volatile copper halide products 8 can be re-deposited onto the copper surface which preferably has to be avoided. The maximum allowable concentration of the volatile copper halide products 8 in the reaction chamber can be derived from the following equation:

$$S = \frac{P_a}{P_e} \qquad\qquad [1]$$

in which S is the saturation ratio of the gas phase in the reaction chamber, $P_a$ is the real partial pressure of the volatile copper halide products 8 in the reaction chamber and $P_e$ the theoretical equilibrium partial pressure of volatile copper halide products 8 at a given pressure and temperature.

The partial pressure of the volatile copper halide products 8 in the reaction chamber can be influenced by the incoming gas flow(s) in the reaction chamber (e.g. He gas flow). The following equation [2] describes the relationship of the incoming gas flow on the actual concentration of gasses in the reaction chamber at a given pressure and temperature:

$$D = D_0 \frac{T}{T_0} \frac{P_0}{P} \qquad\qquad [2]$$

in which Do, To, $P_0$ are respectively the gas flow, temperature (25°C) and pressure (1 atm) of the incoming gas (He) and D, T en P the actual flow, temperature and pressure in the reaction chamber. Since, according to embodiments of the invention, the substrate 1 is kept at low temperature, special attention has to be paid to the removal of volatile copper halide products 8 out of the reaction chamber. This requires in general that the incoming gas flow rate is correlated to the exhaust flow rate. For example, the incoming gas flow for He may be e.g. higher than 250 sccm at the standard operation pressure (5 mTorr (0.67 Pa) up to 80 mTorr (10.67 Pa)). Preferably the volatile copper halide products 8 may be removed from the reaction chamber through the exhaust.

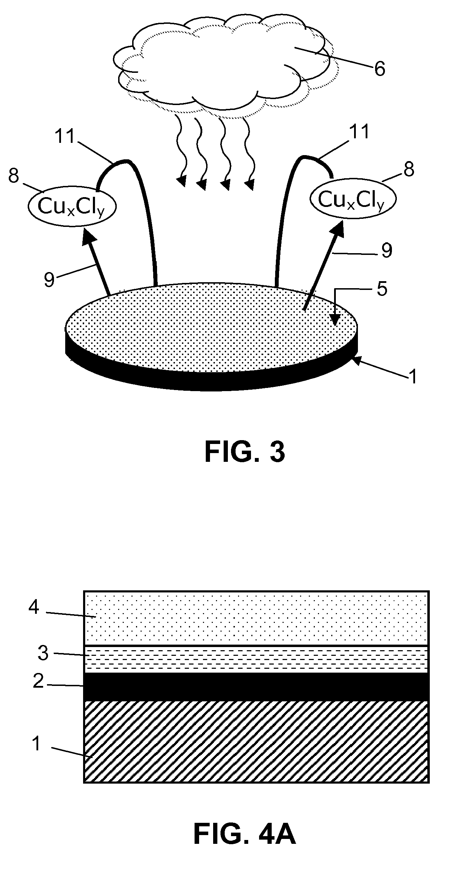

Fig. 3 schematically illustrates in more detail the exposure of the copper halide surface layer 5 to the photon comprising ambient 6. This exposure results in formation 9 of volatile copper halide products 8, in the example given $Cu_xCl_y$, which can, upon saturation of these volatile copper halide products 8 in the reaction chamber, be re-deposited (indicated by arrow with reference number 11 in Fig. 3) onto the substrate 1. Therefore, and as described above, the volatile copper halide products 8, in embodiments of the present invention, may be removed from the reaction chamber during exposure of the copper halide surface layer 5 to the photon comprising ambient 6 to avoid saturation of the volatile copper halide products 8 in the reaction chamber.

The method according to embodiments of the invention can, for example, be used for patterning a copper comprising layer. For example, the method according to embodiments of the invention may be used for patterning interconnect structures in a copper comprising layer of semiconductor devices.

Figs. 4A to 4F illustrate different processing steps in a method for patterning a copper comprising layer using a method according to embodiments of the present invention to remove (etch) part of the copper comprising layer. It has to be understood that this example is only for the purpose of illustration and is not intended to limit the invention in any way. According to other embodiments, the method may furthermore comprise other steps, or may comprise a different sequence of steps.

In a first step, a substrate 1 may be provided with a protecting layer 2 and a barrier layer 3. As described earlier, the substrate 1 may be any suitable substrate 1. The protecting layer 2 may, for example, be a $SiO_2$ layer, and may, for example, have a thickness of 500 nm. The barrier layer 3 may, for example, be a TaN, TiN, TaN/TiN or SiC layer and may have a thickness in the range of, for example, 10 nm to 20 nm. It has to be noted that the provision of a protecting layer 2 and a barrier layer 3 is optional. According to other embodiments of the invention, only one of a protecting layer 2 or a barrier layer 3 may be present. According to still further embodiments, however, none of these layers 2, 3 may be present.

On top of the barrier layer 3 a copper comprising surface layer 4 is provided (see Fig. 4A). The copper comprising surface layer 4 may, for example, be deposited by known deposition techniques such as Plasma Vapor Deposition (PVD) or Electrochemical Deposition (ECD) or electroless plating. The copper comprising surface layer 4 may, for example, have a thickness between 200 nm and 1000 nm. However, according to embodiments of the invention the copper comprising surface layer 4 may also have a thickness of larger than 1000 nm. The initial thickness of the copper comprising surface layer 4, i.e. the thickness of the copper comprising surface layer 4 before patterning may be dependent on the application. For example, when the copper comprising layer has to be patterned to form interconnect structures such as trenches or vias in a semiconductor device, the thickness of the copper comprising surface layer 4 may be between 1 nm to 10000 nm.

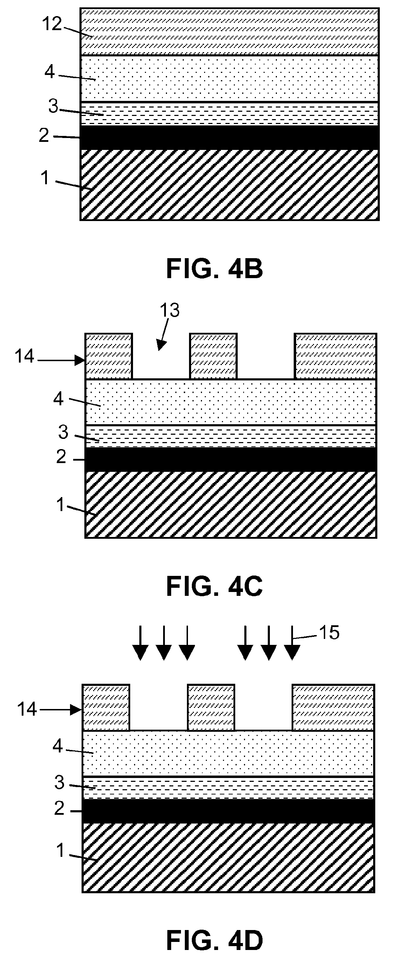

To pattern the copper comprising surface layer 4, a sacrificial pattern may first be provided onto the copper comprising surface layer 4. The sacrificial pattern may be provided on top of the copper comprising surface layer 4 such that some parts of the copper comprising surface layer 4 are exposed and other parts of the copper comprising surface layer 4 are covered by the sacrificial pattern. Therefore, a sacrificial layer 12 may be provided, e.g. deposited on top of the copper comprising surface layer 4 (see Fig. 4B) and holes or openings 13 may the be formed in this sacrificial layer 12 to form the sacrificial pattern 14 (see Fig. 4C). This may be done by means of any suitable method, for example, a combination of lithographic patterning and etching as known by a person skilled in the art. The sacrificial layer 12 may, for example, comprise one or more photosensitive layers (resist) or a combination of photosensitive layers (resist) and commonly used hardmask layers such as e.g. $SiO_x$. According to embodiments of the invention, the sacrificial pattern 14 may be a dummy pattern or, in other words, may be a sacrificial pattern that may be removed after copper etching. Alternatively the sacrificial pattern 14 may be a permanent pattern that will not be removed afterwards. The permanent pattern can then, for example, be used as a barrier material.

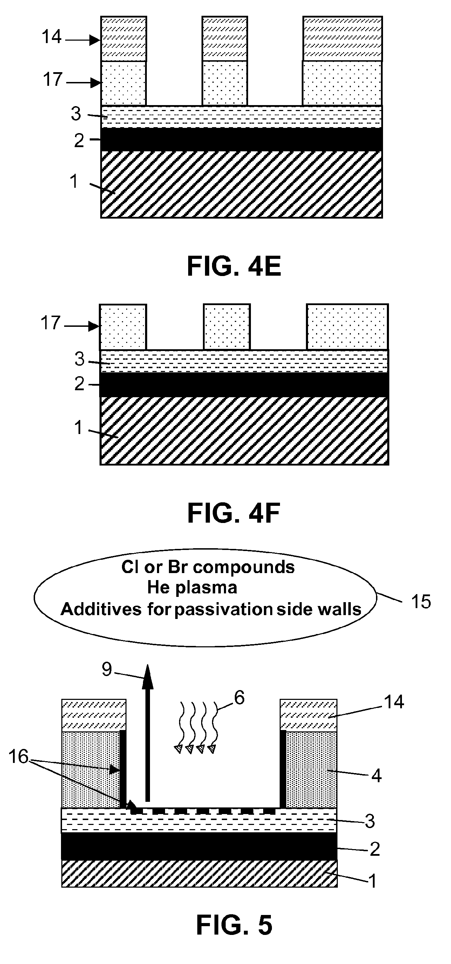

In a next step which is illustrated in Fig. 4D, the non-covered parts of the copper comprising surface layer 4 are converted into a copper halide surface layer 5 (see Fig. 5), i.e. a surface layer comprising a copper halide compound, e.g. a copper halide compound different from a copper fluoride compound. These converted parts are then exposed to a photon comprising ambient 6 to make the copper halide compound volatile at room temperature. According to the present example, these two steps may be performed simultaneously in a same reaction chamber. However, this is only an example and is not intended to limit the invention in any way. As already mentioned above, these two steps may also be performed subsequently and/or in different reaction chambers. According to the present example, converting the copper comprising surface layer 4 into a copper halide surface layer 5 and exposing these converted parts to a photon comprising ambient 6 (see Fig. 5) may be done by exposing these parts to a halogen comprising ambient, e.g. chloride or bromide comprising ambient, in which a photon inducing compound is present e.g. originating from a He, Ar or $H_2$ plasma (indicated with reference number 15 in Fig. 5 and in Fig. 4D). The ambient 15 may furthermore comprise inert compounds and/or compounds such as fluorocarbon based compounds (e.g. $CF_4$) to obtain passivation 16 (e.g. sidewall and/or bottom wall passivation) during etching as shown in Fig. 5.

According to embodiments of the invention, optionally, the copper comprising surface layer 4 may, before exposing to the halogen comprising ambient (plasma) 15, first be cleaned to remove possible contaminants. In case the contaminant is, for example, $CuO_x$, a $H_2$ or $N_2$ plasma may be used.

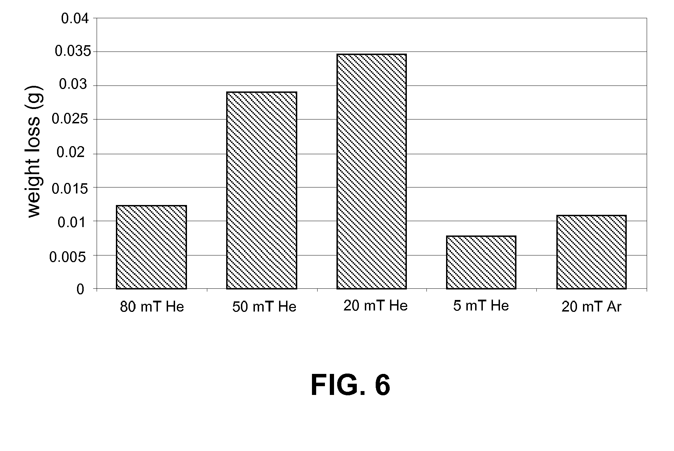

Gas pressure during exposure of the copper halide surface layer 5 to the photon comprising ambient 6 may be an important parameter. Fig. 6 illustrates gas pressure of a He gas during exposure of the copper halide surface layer. By tuning the He gas pressure for a fixed He flow of 500 sccm the removal (etch) rate can be increased. Lower He gas pressures (in the range of 80 mTorr (10.67 Pa) He down to 20 mTorr (2.66 Pa) (see three bars at the left hand side of Fig. 6)) may lead to more efficient removal (etching) of copper halide products 8 which is illustrated in Fig. 6 as weight loss of copper. Too low gas pressure however, e.g. 5mTorr (0.67 Pa) or lower, may result in inefficient removal of copper halide products 8. This low gas pressure leads probably to a change from a transition flow regime into a molecular flow regime and to a low intensity of the He plasma. When comparing a He comprising gas to an Ar comprising gas used for the same purpose, it is illustrated (bar at the right hand side of Fig. 6) that an Ar comprising gas is less efficient than the He comprising gas at a same pressure.

Hence, according to embodiments of the invention, efficient removal (etching) of copper from a copper comprising surface layer can be obtained by good control of the partial pressure of halogenated copper products as well as (or in other words in combination with) the kind, intensity and/or power of the plasma and more specifically of the intensity of the photons in the plasma. The conditions of the plasma may further depend on the surface area of the copper comprising surface layer to be etched.

Fig. 4E illustrates the copper comprising structures 17 obtained after etching the copper comprising surface layer 4 using a method according to embodiments of the invention. These copper comprising structures 17 may, for example, be used to define interconnect structures in Back-End-of-Line (BEOL) processing of a semiconductor device.

In a last step, the sacrificial pattern 14 may be removed (see Fig. 4F). Removal of the sacrificial pattern 14 may be performed by any suitable technique known by a person skilled in the art. It has to be noted that, as already said above, according to other embodiments of the invention, the sacrificial pattern 14 does not have to be removed. According to these embodiments, the pattern 14 may then serve as e.g. a barrier layer.

The method described above for etching or patterning of a copper comprising layer may, for example, be performed in a Lam Versys 2300 generation (ICP plasma etcher) etch chamber. According to embodiments of the invention the pressure in the plasma chamber may be in the range of between 5 mTorr (0.67 Pa) and 80 mTorr (10.67 Pa) to obtain removal of copper using the method of the invention.

It is to be understood that although preferred embodiments, specific constructions and configurations, as well as materials, have been discussed herein for devices according to the present invention, various changes or modifications in form and detail may be made without departing from the scope of this invention as defined by the appended claims.

**Claims**

1. A method for removing at least part of a copper comprising layer (4) from a substrate (1), the substrate (1) comprising at least a copper comprising surface layer (4), the method comprising:

   - in a first reaction chamber converting at least part of the copper comprising surface layer (4) into a copper halide surface layer (5),
   - in a second reaction chamber removing at least part of the copper halide surface layer (5) by exposing it to a photon comprising ambient (6), thereby initiating formation of volatile copper halide products (8), and
   - during exposure to the photon comprising ambient (6), removing the volatile copper halide products (8) from the second reaction chamber to avoid saturation of the volatile copper halide products (8) in the second reaction chamber.

2. Method according to claim 1, wherein converting at least part of the copper comprising surface layer (4) into a copper halide surface layer (5) is performed by exposing at least part of the copper comprising surface layer (4) to a halogen comprising gas.

3. Method according to claim 1, wherein converting at least part of the copper comprising surface layer (4) into a copper halide surface layer (5) is performed by exposing at least part of the copper comprising surface layer (4) to a halogen comprising plasma.

4. Method according to claim 3, wherein exposing at least part of the copper comprising surface layer (4) to a halogen comprising plasma is performed at a power of between 200 Watt and 1000 Watt, a pressure of between 0.53 Pa and 10.67 Pa and a flow rate of between 50 sccm and 500 sccm.

5. Method according to claim 3 or 4, wherein the halogen comprising plasma comprises $BCl_3$, HBr, $Br_2$, $Cl_2$, $I_2$, HCl and/or HI gasses.

6. Method according to any of the previous claims, wherein exposing the copper halide surface layer (5) to a photon comprising ambient (6) is performed by exposing the copper halide surface layer (5) to a He, Ar or H comprising plasma.

7. Method according to claim 6, the copper halide surface layer (5) comprising $Cu_xCl_y$ and the photon comprising ambient (6) being a He plasma, wherein exposing the copper halide surface layer (5) to the photon comprising ambient (6) is performed at a power of 1000 Watt and a pressure of 30 mTorr.

8. Method according to claim 6, the copper halide surface layer comprising $Cu_xBr_y$ and the photon comprising ambient (6) being a He plasma, wherein exposing the copper halide surface layer (5) to the photon comprising ambient (6) is performed at a power of 1000 Watt and a pressure of 80 mTorr.

9. Method according to any of the previous claims, wherein converting at least part of the copper comprising surface layer (4) into a copper halide surface layer (5) and exposing the copper halide surface layer (5) to a photon comprising ambient (6) are performed simultaneously in a same reaction chamber.

10. Method according to any of the previous claims, wherein the method furthermore comprises, before converting at least part of the copper comprising surface layer (4) into a copper halide surface layer (5), providing a pattern (14) onto the copper comprising surface layer (4).

11. Method according to claim 10, wherein providing a pattern (14) onto the copper comprising surface layer (4) is performed by:

    - providing a layer (12) of photosensitive material onto the copper comprising surface layer (4), and
    - patterning said layer (12) of photosensitive material by lithographic patterning to create at least one hole (13) in the layer (12).

12. Method according to claim 10 or 11, wherein the method furthermore comprises, after provision of a pattern (14) onto the copper comprising surface layer (4) and removing at least part of the copper comprising surface layer (4), removing the photosensitive material.

13. Method according to any of the previous claims, wherein the method furthermore comprises, before converting at least part of the copper comprising surface layer (4) into a copper halide surface layer (5), cleaning the substrate (1).

14. Use of the method according to any of the previous claims for patterning a copper comprising layer.

15. Use of the method according to any of claims 1 to 13 for patterning interconnect structures in a copper comprising layer of semiconductor devices.

**FIG. 1**

**FIG. 2**

**FIG. 3**

**FIG. 4A**

FIG. 4B

FIG. 4C

FIG. 4D

**FIG. 4E**

**FIG. 4F**

Cl or Br compounds
He plasma
Additives for passivation side walls

**FIG. 5**

**FIG. 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5221426 A


**Non-patent literature cited in the description**

- **KUO et al.** Room-temperature copper etching based on a plasma-copper reaction. *Applied Physics Letters,* 2001, vol. 78 (7